# FASCICULE DE BREVET EUROPEEN

(11) **EP 0 227 542 B1**
(45) Date de publication et mention de la délivrance du brevet: **16.06.1993**
(21) Numéro de dépôt: 86402783.4
(22) Date de dépôt: 12.12.1986
(51) Int. Cl.: C23C 14/06, C23C 14/35

(54) **Couches minces de métal condensé sur un substrat et contenant carbone ou azote en solution d'insertion**
Dünne Schichten aus metallischem Niederschlag auf einem Substrat, welche Kohlenstoff und Stickstoff in Lösung enthalten
Thin films of metallic condensations on a substrate and containing carbon and nitrogen in solution

(30) Priorité: 16.12.1985 FR 8518579
(43) Date de publication de la demande: 01.07.1987
(73) Titulaire: CENTRE STEPHANOIS DE RECHERCHES MECANIQUES HYDROMECANIQUE ET FROTTEMENT Société dite:, F-42160 Andrezieux Boutheon (FR)
(72) Inventeur: Terrat, Jean-Paul, F-42000 Saint-Etienne (FR); Tremoureux, Yves, F-42100 Saint-Etienne (FR); Gaucher, Antoine, 42160 Andrezieux-Boutheon (FR)
(74) Mandataire: CABINET BONNET-THIRION

(56) Documents cités:
- EP-A- 0 074 322
- DD-C- 146 306
- FR-A- 2 528 452
- US-A- 2 920 002
- US-A- 4 125 446
- THIN SOLID FILMS, vol. 8, no. 1, juillet 1971, pp. 69-79, Elsevier Sequoia SA, Lausanne, CH; J.DUCHENE: "Radiofrequency reactive sputtering for depostion of aluminium nitride thin films"
- LE VIDE, LES COUCHES MINCES, vol. 196, 1979, pp. 343-352, Paris, FR; J.J.HANTZPERQUE et al.: "Etude du mecanisme de formation et des proprietés électriques et structurales des cermets A1/A1n déposés par pulvérisation cathodique réactive"
- LE VIDE, LES COUCHES MINCES, vol. 225, janvier-février 1985, pp. 13-32, Paris, FR; J.J.HANTZPERQUE et al.: "Kinetics and mechanism of reactive sputtering of aluminium by ions N2+ and Ar+"

## Description

L'invention se rapporte à des couches minces polycristallines d'un métal, obtenues par condensation du métal sur le substrat et comportant un élément d'addition, soit carbone, soit azote, en solution d'insertion dans le réseau cristallin. L'invention se rapporte également à un procédé de préparation d'une telle couche.

On connaît par FR-A-2 512 070 des couches de chrome, à haute densité, obtenues par pulvérisation cathodique réactive et comportant, en solution solide d'insertion, un élément, notamment carbone, à des teneurs supérieures à celles que laissent prévoir les diagrammes d'équilibre thermodynamiques. Ainsi pour le couple chrome carbone la limite maximale de teneur de solution solide en équilibre thermodynamique est de 0,2 % en poids, et au-delà de cette limite il se forme un carbure de chrome. Or par pulvérisation cathodique réactive en atmosphère argon/méthane ou acétylène, on obtient des solutions solides d'insertion contenant jusqu'à 3 % en poids de carbone.

Les couches obtenues font preuve d'une très grande dureté, sans la fragilité inhérente aux couches minces qui contiennent des carbures, la dureté croissant de façon monotone avec la teneur en carbone.

La Demanderesse a découvert que dans l'aluminium, bien que, en équilibre thermodynamique, la solubilité d'insertion du carbone et de l'azote soit inférieure à 0,0001 % en poids, ce qui correspond approximativement à 2 atomes d'élément d'addition par million d'atomes d'aluminium, il était possible, par pulvérisation cathodique en atmosphère réactive, d'inclure jusqu'à au moins 130 atomes d'élément d'addition pour mille atomes d'aluminium, et que les couches résultantes présentaient des propriétés singulières, très différentes des couches de chrome.

Aussi l'invention propose une couche mince polycristalline d'un métal obtenue par condensation du métal sur un substrat conducteur et comportant un élément d'addition, soit carbone, soit azote en solution solide d'insertion à des teneurs hors équilibre thermodynamique dans le réseau cristallin, caractérisée en ce que le métal condensé est l'aluminium, et contient l'élément d'addition en proportion de 9 à 110 atomes pour mille d'aluminium.

On a constaté que certaines propriétés, telles que la dimension de la maille cristalline, la dureté superficielle et la résistance électrique de contact présentaient des extremums (maximums de dureté et de déformation de la maille, minimum de résistance électrique de contact) pour une proportion de 29 à 35 atomes d'élément d'addition pour mille d'aluminium. On a constaté en outre que, pour des teneurs en deçà de 29-35 atomes d'élément d'addition pour mille d'aluminium, en diffraction de rayons X seuls apparaissent les pics caractéristiques de l'aluminium, tandis qu'au-delà de cette valeur, à côté des pics de l'aluminium il apparaissait des pics caractéristiques de carbure ou de nitrure.

La teneur correspondant aux extremums apparaît ainsi comme une saturation de l'aluminium par les éléments d'insertion.

L'existence d'extremums implique qu'il existe des paires de teneurs, de part et d'autre de la teneur d'extremum, pour lesquelles les valeurs de dureté et de résistance électrique de contact sont sensiblement les mêmes ; ainsi pour des teneurs de 16 et 70 atomes d'élément d'addition pour 1000 atomes d'aluminium on a sensiblement la même dureté et la même résistance électrique de contact, intermédiaire entre les valeurs relatives à l'aluminium pur, et à l'aluminium saturé en élément d'addition (hors équilibre thermodynamique).

L'invention propose également un procédé de préparation, sur un substrat conducteur, d'une couche mince polycristalline d'un métal comportant un élément d'addition, soit carbone, soit azote, en solution solide d'insertion à des teneurs hors équilibre thermodynamique dans le réseau cristallin, procédé où l'on pulvérise une cible constituée dudit métal, cathodique par rapport au substrat, dans une atmosphère de gaz rare sous pression réduite telle qu'un plasma soit créé entre cible et substrat, l'atmosphère contenant un gaz réactif apte à donner naissance à des ions de l'élément d'addition dans le plasma, sous une pression partielle réglée, caractérisé en ce que ledit métal est l'aluminium, la pression partielle de gaz réactif étant réglée en sorte que le substrat reçoive de 9 à 110 atomes de l'élément d'addition pour mille d'aluminium.

On remarquera que la teneur en élément d'addition de la couche préparée varie sensiblement comme la pression partielle du gaz apte à former des ions de l'élément d'addition dans le plasma. L'étalonnage d'une installation de pulvérisation cathodique, par quelques essais préliminaires, permettra de régler la teneur des couches préparées en élément d'addition de façon répétable.

Dans le cas où l'élément d'addition est le carbone, le gaz apte à former des ions de carbone sera un hydrocarbure ne contenant pas plus de deux atomes de carbone dans la molécule, et de préférence le méthane. Dans le cas où l'élément d'addition est l'azote, le gaz peut être l'ammoniac ou simplement de l'azote moléculaire.

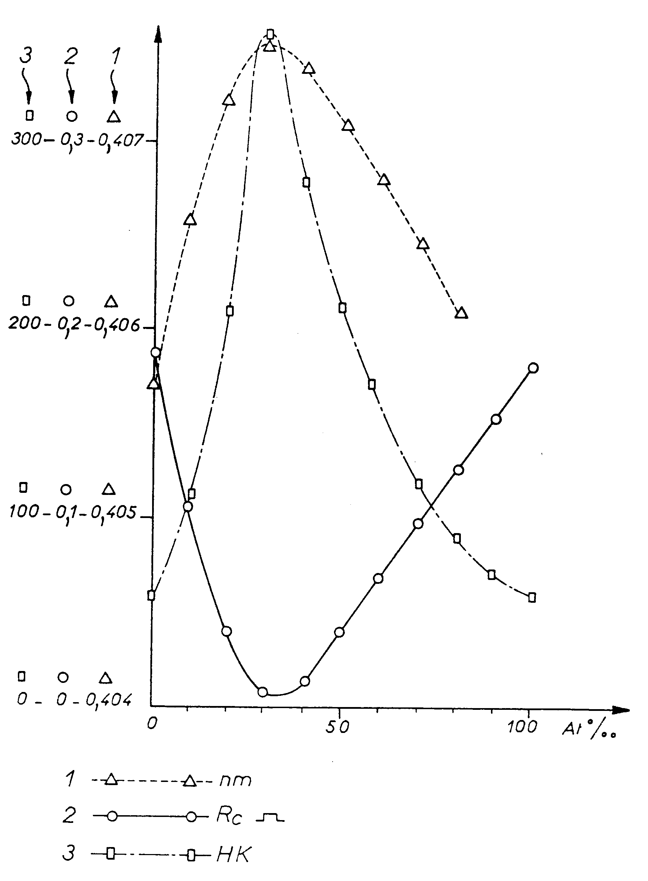

Des caractéristiques secondaires et les avantages de l'invention ressortiront d'ailleurs de la description qui va suivre, à titre d'exemple, en référence au dessin unique annexé qui est un diagramme représentant les duretés, résistances de contact et dimensions de la maille des couches d'aluminium de l'invention, avec de l'azote en solution d'insertion.

On précise, en préliminaire, les processus de mesure des paramètres dont les variations sont rapportées sur la figure unique. Les couches d'expérience présentaient une épaisseur constante de 10 micromètres, sauf indication contraire. La maille cristalline était mesurée par diffraction de rayons X, de façon classique. La dureté superficielle était mesurée à l'aide d'un microduromètre Knoop (pénétrateur en forme de pyramide en base losange). La résistance de contact a été déterminée par une méthode utilisée par les fabricants de contacts électriques, notamment pour connecteurs de circuits imprimés ou intégrés. La résistance de contact est déterminée en faisant reposer sur la surface à essayer une bille, de 1,5 mm de diamètre, sous une charge de 0,25 N, et en mesurant la différence de potentiel entre substrat et bille pour un courant traversant de 80 mA (valeur moyenne de deux mesures avec inversion du sens du courant).

Les couches d'essais ont été effectuées sur un appareil de pulvérisation cathodique, du type dit magnétron où un champ magnétique, est croisé avec le champ électrique créé entre cible et substrat, reliés respectivement aux pôles négatif et positif d'une source de tension continue. La distance entre cible d'aluminium et substrat, en acier dans le cas présent, était comprise entre 5 et 20 cm, la pression totale comprise entre 0,1 et 1 Pa (pression d'argon plus pression d'azote ou de méthane), la pression partielle de gaz réactif étant comprise entre 10⁻² et 10⁻⁴ Pa, et la puissance spécifique de la décharge dans le plasma était comprise entre 10 et 20 watts par centimètre carré de cible. Dans ces conditions la vitesse de croissance en épaisseur de la couche était voisine de 12,5 nm/s, c'est-à-dire que la pulvérisation durait environ 13 minutes pour une épaisseur de 10 µm et 20 minutes pour une épaisseur de 15 µm, épaisseur maximale pratique.

Les premiers essais ont été exécutés avec comme gaz réactif de l'azote moléculaire. La quantité d'azote introduite dans la couche était très sensiblement proportionnelle à la pression partielle d'azote admise dans l'enceinte de pulvérisation avec l'argon.

On a opéré sur une série d'échantillons avec des couches d'épaisseur 10 µm à teneur progressivement croissante en azote jusqu'à 100 atomes d'azote pour mille d'aluminium, en procédant chaque fois à des mesures de maille de l'aluminium, de dureté Knoop, et de résistance électrique de contact. Les résultats sont reportés sur la figure unique.

On constate que la microdureté et la maille croissent parallèlement jusqu'à ces maximums qui correspondent à 29-36 atomes pour mille d'aluminium, puis décroissent pour retrouver les valeurs de départ pour 100 à 105 atomes d'azote pour mille d'aluminium. Pour l'aluminium pur la maille est de 40,57 nm et croît jusqu'à 40,75 nm pour la valeur singulière 29-36 atomes d'azote pour mille d'aluminium. Par ailleurs la dureté Knoop passe de 60 HK (60 MPa) pour l'aluminium pur à 360 HK (360 MPa) pour la valeur singulière de la teneur en azote de la couche.

Si l'on considère la résistance de contact, on remarque qu'elle subit des variations inverses de variations de dureté et de dimension de maille, passant de 0,19 ohm pour l'aluminium pur à 0,008 ohm pour la valeur singulière de 29-36 atomes d'azote pour mille d'aluminium, puis remontant à sa valeur de départ pour environ 105 atomes d'azote pour 1000 d'aluminium.

Comme on l'a déjà signalé, la valeur singulière semble correspondre à une saturation de l'azote d'insertion, les diagrammes de diffraction X ne présentant que le spectre de l'aluminium pur jusqu'à la valeur singulière, et les spectres de l'aluminium et de nitrure au-delà.

On avait observé dans le cas du chrome un phénomène analogue de saturation. Toutefois outre que l'apparition de carbure de chrome correspond à 130 au moins atomes de carbone par mille de chrome (3 % en poids), la teneur de saturation ne correspond pas à un extremum des propriétés physiques. Notamment la dureté présente une croissance monotone avec la teneur en carbone.

Lorsque l'on répète les essais de dépôt de couches d'aluminium en utilisant comme gaz réactif le méthane, on obtient des solutions solides d'insertion de carbone, dont les propriétés sont extrêmement proches de celles des couches à solution solide d'azote, avec une teneur singulière de 29-36 atomes de carbone pour mille d'aluminium, c'est-à-dire la même valeur que pour l'azote, dans les limites de précision des déterminations des teneurs en élément d'addition. Les variations de propriétés sont les mêmes avec le carbone et avec l'azote, ce qui laisse à penser que les affinités chimiques entre l'aluminium et les éléments d'addition ne jouent pas de rôle important dans les phénomènes, et que l'insertion dans le réseau cristallin est due à un piégeage de l'élément d'addition par la condensation de l'aluminium. On peut opérer en présence d'acétylène au lieu de méthane, sans avantage apparent.

Sous un autre aspect la formation de la solution d'insertion s'effectue à une température relativement basse, que l'on peut estimer aux environs de 200°C. A ces températures les vitesses de diffusion de l'élément d'addition dans l'aluminium sont extrêmement réduites, de sorte que les solutions solides d'insertion, en état thermodynamiquement métastable, n'évoluent pratiquement pas aux températures proches de l'ambiante.

Les couches d'aluminium contenant de l'azote ou du carbone en solution solide d'insertion, et tout particulièrement celles dont la teneur en élément d'addition est proche de la saturation (29-36 atomes d'élément d'addition pour mille d'aluminium) apparaissent comme bien adaptées à la réalisation de contacts de connexions électriques, en raison de leur dureté relativement élevée (360 HK) soit une dureté six fois plus élevée que celle de l'aluminium pur, et une résistance électrique de contact inférieure à 10 mΩ, soit sept fois inférieure à celle du cuivre déposé en couche de même épaisseur (70 mΩ). De telles couches d'aluminium contenant de l'azote ou du carbone en solution d'insertion présenteraient des performances qui les rendraient compétitives avec les couches d'or pour des connexions de circuits imprimés, de circuits intégrés et de connecteurs à contacts multiples.

## Revendications

1. Couche mince polycristalline d'un métal obtenue par condensation du métal sur un substrat conducteur et comportant un élément d'addition, soit carbone, soit azote en solution solide d'insertion à des teneurs hors équilibre thermodynamique dans le réseau cristallin, caractérisée en ce que le métal condensé est l'aluminium, et contient l'élément d'addition en proportion de 9 à 110 atomes pour mille d'aluminium.

2. Couche mince selon la revendication 1, caractérisée en ce que l'élément d'addition est présent en proportion de 16 à 70 atomes pour 1000 d'aluminium.

3. Couche mince selon la revendication 2, caractérisée en ce que l'élément d'addition est présent en proportion de 29 à 36 atomes pour mille d'aluminium.

4. Couche mince selon une quelconque des revendications 1 à 3, caractérisée en ce que son épaisseur est comprise entre 1 et 15 µm.

5. Procédé de préparation, sur un substrat conducteur, d'une couche mince polycristalline d'un métal comportant un élément d'addition, soit carbone, soit azote, en solution solide d'insertion à des teneurs hors équilibre thermodynamique dans le réseau cristallin, procédé où l'on pulvérise une cible constituée dudit métal, cathodique par rapport au substrat, dans une atmosphère de gaz rare sous pression réduite telle qu'un plasma soit créé entre cible et substrat, l'atmosphère contenant un gaz réactif apte à donner naissance à des ions de l'élément d'addition dans le plasma, sous une pression partielle réglée, caractérisé en ce que ledit métal est l'aluminium, la pression partielle de gaz réactif étant réglée en sorte que le substrat reçoive de 9 à 110 atomes de l'élément d'addition pour mille d'aluminium.

6. Procédé suivant la revendication 5, où l'élément d'addition est le carbone, caractérisé en ce que le gaz réactif est un hydrocarbure contenant au plus deux atomes de carbone dans sa molécule.

7. Procédé suivant la revendication 6, caractérisé en ce que l'hydrocarbure est le méthane.

8. Procédé suivant la revendication 5, où l'élément d'addition est l'azote, caractérisé en ce que le gaz réactif est de l'azote moléculaire.

9. Procédé suivant une quelconque des revendications 5 à 8, caractérisé en ce que le plasma est obtenu par une combinaison d'un champ électrique entre cible et substrat, et d'un champ magnétique croisé avec le champ électrique.

10. Procédé suivant une quelconque des revendications 5 à 9, caractérisé en ce que la pression totale de l'atmosphère de gaz rare étant comprise entre 0,1 et 1 Pa, la pression partielle de gaz réactif est comprise entre 10⁻² et 10⁻⁴ Pa.

## Claims

1. Polycrystalline thin film of a metal obtained by condensation of the metal on a conductive substrate and including an element of addition, either carbon or nitrogen, inserted in the crystal lattice to form a solid solution in an amount outside thermodynamic equilibrium, characterised in that the condensed metal is aluminium, and contains the element of addition in a proportion of 9 to 110 atoms per thousand of aluminium.

2. Thin film according to Claim 1, characterised in that the element of addition is present in a proportion of 16 to 70 atoms per 1000 of aluminium.

3. Thin film according to Claim 2, characterised in that the element of addition is present in a proportion of 29 to 36 atoms per thousand of aluminium.

4. Thin film according to any one of Claims 1 to 3, characterised in that its thickness is between 1 and 15 µm.

5. Method of preparing, on a conductive substrate, a polycrystalline thin film of a metal including an element of addition, either carbon or nitrogen, inserted in the crystal lattice to form a solid solution in an amount outside thermo-dynamic equilibrium, a method in which a target consisting of the said metal, cathodic with respect to the substrate, is atomised in an atmosphere of inert gas at reduced pressure such that a plasma is created between the target and substrate, the atmosphere containing a reactive gas suitable for giving rise to ions of the element of addition in the plasma, at an adjusted partial pressure, characterised in that the said metal is aluminium, the partial pressure of reactive gas being adjusted so that the substrate receives between 9 and 110 atoms of the element of addition per thousand of aluminium.

6. Method according to claim 5, in which the element of addition is carbon, characterised in that the reactive gas is a hydrocarbon containing at the most two atoms of carbon in its molecule.

7. Method according to claim 6, characterised in that the hydrocarbon is methane.

8. Method according to claim 5, in which the element of addition is nitrogen, characterised in that the reactive gas is molecular nitrogen.

9. Method according to any one of Claims 5 to 8, characterised in that the plasma is obtained by a combination of an electrical field between target and substrate and a magnetic field crossed with the electrical field.

10. Method according to any one of Claims 5 to 9, characterised in that, the total pressure of the atmosphere of inert gas being between 0.1 and 1 Pa, the partial pressure of reactive gas is between 10⁻² and 10⁻⁴ Pa.

## Patentansprüche

1. Dünne polykristalline Schicht eines Metalls, die man durch Kondensation des Metalls auf einem leitenden Substrat erhält, und die ein Legierungselement, entweder Kohlenstoff oder Stickstoff in fester Lösung mit Gehalten außerhalb des thermodynamischen Gleichgewichts in dem kristallinen Netz aufweist, dadurch gekennzeichnet, daß das kondensierte Metall Aluminium ist und sie das Legierungselement in einem Verhältnis von 9 bis 110 Atomen auf tausend Aluminiumatome enthält.

2. Dünne Schicht nach Anspruch 1, dadurch gekennzeichnet, daß das Legierungselement in einem Verhältnis von 16 bis 70 Atomen auf 1000 Aluminiumatome vorliegt.

3. Dünne Schicht nach Anspruch 2, dadurch gekennzeichnet, daß das Legierungselement in einem Verhältnis von 29 bis 36 Atomen auf tausend Aluminiumatome vorliegt.

4. Dünne Schicht nach irgendeinem der Ansprüche 1 bis 3, dadurch gekennzeichnet, daß ihre Dicke zwischen 1 und 15 µm liegt.

5. Herstellungsverfahren einer dünnen polykristallinen Schicht eines Metalls auf einem leitenden Substrat, die ein Legierungselement, entweder Kohlenstoff oder Stickstoff in fester Lösung in Gehalten außerhalb des thermodynamischen Gleichgewichts in dem kristallinen Netz aufweist, wobei in dem Verfahren ein Target, das aus dem bezüglich des Substrats kathodischen Metall gebildet ist, in einer Edelgasatmosphäre unter vermindertem Druck zerstäubt wird, so daß ein Plasma zwischen dem Target und dem Substrat geschaffen wird, wobei die Atmosphäre ein reaktives Gas zur Bildung von Ionen des Legierungselementes in dem Plasma unter einem eingestellten Teildruck enthält, dadurch gekennzeichnet, daß das Metall Aluminium ist und der Teildruck des reaktiven Gases so eingestellt ist, daS das Substrat von 9 bis 110 Atome des Legierungselementes auf tausend Aluminiumatome erhält.

6. Verfahren nach Anspruch 5, wo das Legierungselement Kohlenstoff ist, dadurch gekennzeichnet, daß das reaktive Gas eine Kohlenwasserstoffverbindung ist, die höchstens zwei Kohlenstoffatome in ihrem Molekül enthält.

7. Verfahren nach Anspruch 6 , dadurch gekennzeichnet, daß die Kohlenwasserstoffverbindung Methan ist.

8. Verfahren nach Anspruch 5, wo das Legierungselement Stickstoff ist, dadurch gekennzeichnet, daß das reaktive Gas molekularer Stickstoff ist.

9. Verfahren nach irgendeinem der Ansprüche 5 bis 8, dadurch gekennzeichnet, daß das Plasma durch eine Kombination eines elektrischen Feldes zwischen Target und Substrat und eines mit dem elektrischen Feld gekreuzten Magnetfeldes gewonnen wird.

10. Verfahren nach irgendeinem der Ansprüche 5 bis 9, dadurch gekennzeichnet, daß der Gesamtdruck der Edelgasatmosphäre zwischen 0,1 und 1 Pa, der Teildruck des reaktiven Gases zwischen 10⁻² und 10⁻⁴ Pa liegt.
